# EUROPEAN PATENT APPLICATION

(11) **EP 1 221 829 A2**
(43) Date of publication of application: **10.07.2002**
(21) Application number: 02000182.2
(22) Date of filing: 09.01.2002
(51) Int. Cl.: H05K 7/14

(54) **Segmented replaceable backplane system for electronic apparatus**

(30) Priority: 09.01.2001 US 757064
(71) Applicant: TRW Inc., Redondo Beach, California 90278 (US)
(72) Inventor: Kocin, Michael J., Poway, CA 92064 (US)
(74) Representative: Schmidt, Steffen J., Dipl.-Ing.

(57) **Abstract**

A backplane connection system (1) is formed of a primary mother board (3) and a plurality of daughter board backplanes (5, 7, & 9) that electrically interconnect (18, 20, 24 & 26)to and populate the primary mother board. The primary mother board contains the electrical connections to interconnect amongst the various daughter board backplanes. Each daughter board backplane includes connectors (10A, 10B, 10C, 10D, 16A, 16B, 16C, 16D & 28)for connecting to a line replaceable module. Preferably, the functional portions of an integrated electronic system are segregated amongst the daughter board backplanes, allowing each functional portion to reside on or be associated with a respective one of the daughter board backplanes.

## Description

### FIELD OF THE INVENTION

This invention relates to electrical interconnection systems and, more particularly, to a back-plane connection system for integrated electronic systems that permits selective removal, test and replacement of individual electronic modules within the integrated electronic systems.

### BACKGROUND

Large sized multi-layer printed wiring boards, often referred to as a "backplane"; are often used to support and interconnect electronic devices and serve as an electrical interconnection point between smaller sized printed wiring boards, containing functional electronic devices, and electrically interconnect, as appropriate, those electronic devices into an integrated electronic system. The smaller printed wiring boards that populate the backplane are sometimes referred to as electronic modules, or more specifically, to emphasize that the module is able to be readily detached from the backplane, as a Line Replaceable Module. Typically the printed wiring board of the Line Replaceable Modules (LRM's) contain an edge connector that "plugs" into a mating connector on the backplane; and may be easily "unplugged" when necessary.

Backplanes used in complex integrated electronic systems, such as in the individual Communications, Navigation and Identification ("CNI") systems used in the F-22 fighter aircraft, comprise multi-layer printed wiring assemblies which are of an extremely large size and contain a large number of layers. As example, the multi-layer circuit board forming the backplane of the Integrated Communications system for the aircraft was twenty-four by twenty inches in size and contained twenty-eight power, ground and signal layers. Additionally, fifty six RF/coaxial cables were used to provide system inputs and outputs and/or interconnections between various Line Replaceable Modules within the communications system.

To perform system integration and test activities of the foregoing electronic system, the entire complement of LRM's is required to be installed in that single large assembly. Further, any repairs or corrections to the basic backplane required redesign and replacement of the entire backplane assembly, including all cables, connectors, clock distribution hybrids and filter networks. The foregoing test and replacement or repair policy is recognized as complex, time consuming and expensive.

With hardware assemblies of the foregoing type designed for use in military aircraft, once the hardware assembly is placed in service, present practice requires that any changes designed for incorporation within the backplane assembly, as an improvement or update, necessitates manufacture and assembly anew of the entire improved hardware assembly, connectors and cables.

As an advantage, the present invention allows changes, improvements, rework or update of only a portion of the backplane assembly. With the invention, one is able to change only a portion of the design, leaving the remaining hardware intact and operational. The invention thus offers a cost advantage, allows design changes to be implemented and applied more quickly, and reduces overall integration risks in very complex integrated electronic systems.

Accordingly, a principal object of the present invention is to provide a new backplane interconnection system.

Accordingly, another object of the invention is to avoid the necessity of replacing an entire backplane assembly when a functional unit of an integrated electronic system supported by the backplane assembly requires repair or replacement.

A further object of the invention is to provide an approach to more easily and at less expense upgrade one or more functional units of an integrated electronic system.

### SUMMARY

In accordance with the invention, a backplane assembly is subdivided or segmented into smaller assemblies, the later being segregated or partitioned along functional lines, such as RF receiver bands, power supply, digital processing and system security. In this structure the backplane is separated into two levels. A multilayer circuit board, called the primary mother board, of a large area in size, is combined with a number of multi-layer circuit boards of smaller area in size, called the daughter board backplanes. The daughter board backplanes mount to different locations on the upper surface of the primary mother board. Electrical connectors in the daughter board backplane electrically connect to connectors in the primary motherboard. The primary motherboard contains the conductive routing to electrically interconnect through the connectors to the various daughter board backplanes. Standard interface connectors are mounted on the upper side of the daughter boards.

As a backplane assembly, the standard interface connectors on the daughter board backplanes permit external electronic modules, such as the hardware Line Replaceable Modules required of an electronic system to mount and electrically connect to such daughter board backplanes. The daughter board backplanes contain the conductive routing to electrically connect to the standard interface connectors that mount the Line Replaceable Modules.

As an additional feature to the invention, the connection to the primary mother board is made through vias formed in the primary mother board. A series of connector pins, which serve as electrical input and outputs, extend from the bottom side of the daughter board backplane. The pins press-fit into the foregoing vias in the primary mother board. Those connector pins serve as the primary interconnection to the primary motherboard on which the daughter board backplanes are mounted.

When a daughter board backplane is placed into the predefined position on the motherboard, the bottom of that board abuts the top side of the primary mother board, and the connector pins extend into and frictionally engage associated vias within the primary motherboard. The contact pins are short enough in length so as to terminate within the via without protruding from the underside of the primary motherboard. As an advantage, the press fit allows for more convenient assembly and/or removal of the daughter board backplanes from the primary motherboard when desired.

In a more specific aspect to the invention, the primary motherboard contains window passages to permit the underside of a respective daughter board backplane that at least in part overlies a window to be accessed from the opposite side of the primary motherboard. RF and power connections are made via cables and connectors inserted through such windows from the bottom side of the daughter board backplane.

With the invention individual daughter board backplanes may be removed and replaced with an updated form of the daughter board backplane without requiring remanufacture of any other daughter board backplane or the primary mother board. Further, one or more daughter board backplanes may be removed and tested. If a functional unit requires more than one daughter board backplane in order to perform a test of the functional unit, then the daughter board backplanes may be removed from the mother board and electrically connected together by a ribbon cable that connects to one of the primary mother board connectors on each of the daughter board backplanes.

The foregoing and additional objects and advantages of the invention together with the structure characteristic thereof, which was only briefly summarized in the foregoing passages, will become more apparent to those skilled in the art upon reading the detailed description of a preferred embodiment of the invention, which follows in this specification, taken together with the illustrations thereof presented in the accompanying drawings.

### BRIEF DESCRIPTION OF THE DRAWINGS

In the drawings:
Figure 1 illustrates an embodiment of the invention, in a partially exploded not-to-scale perspective view;
Figure 2 illustrates two of the components of the embodiment of Fig. 1 in a bottom perspective view;
Figure 3 is a side section view of some of a connector components of the embodiment of Fig. 1 drawn to a greater scale;
Figure 4 is another side section view of an RF connector component of the embodiment of Fig. 1 drawn in larger scale;
Figure 5 is a section view of an alternative connector component for the connector presented in Fig. 3; and
Figure 6 is a pictorial illustration showing the manner in which a number of the daughter board components of Fig. 1 may be interconnected for test when separated from other components in the embodiment of Fig. 1.

### DETAILED DESCRIPTION OF THE PREFERRED EMBODIMENTS

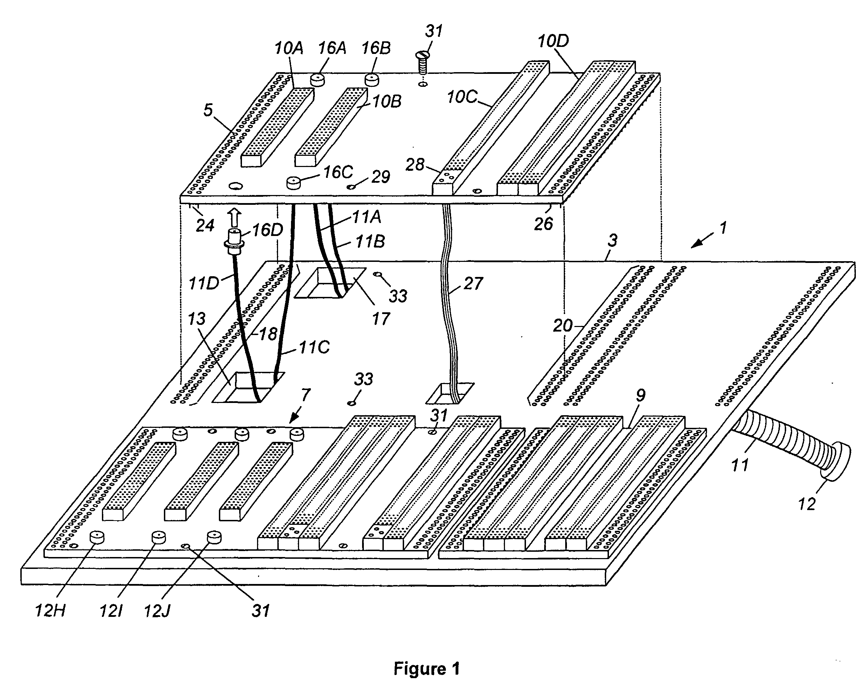

Reference is made to Fig. 1, illustrating a segmented back plane connection system 1 in a partially exploded view. The system includes a primary mother board 3, daughter board backplanes 5, 7 and 9 and a multi-wire RF cable bundle 11. Primary mother board 3 is a multi-layer circuit board that occupies a large flat rectangular area and contains four to six layers (in contrast to the twenty to thirty layers of the prior backplane systems) laminated together. Internally within the layers of the laminate, the primary mother board contains appropriate patterns of conductors, not illustrated, chosen by the designer principally for routing signals to various daughter board backplanes, later herein described. Those conductor patterns are included within the various internal layers of the board. However, the details of those conductor patterns are not material or relevant to the invention, and do not require further description. For reasons which become apparent, the upper surface of the primary mother board is free of any such routing conductors.

The primary mother board 3 supports, as example and not by way of limitation, four daughter board backplanes 5, 7, and 9, only three of which are illustrated, on the upper surface. Daughter boards 7 and 9 are illustrated assembled to primary mother board; while daughter board backplane 5 is illustrated in an exploded view, uplifted from the upper surface of primary mother board 3. A vacant space to the upper right of the primary motherboard could be occupied by a fourth motherboard, if desired.

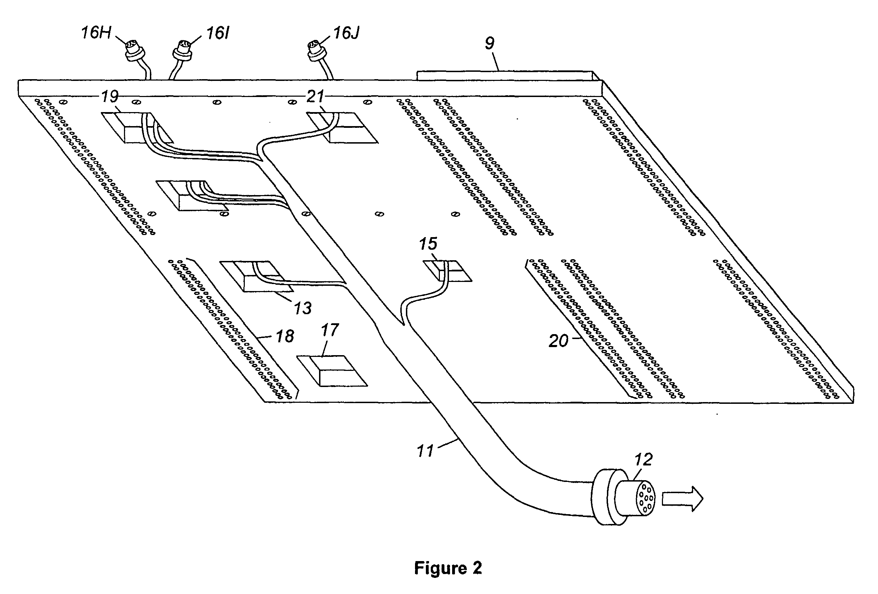

Primary mother board 3 includes a number of rectangular shaped passages, "cut-outs" or, as variously termed, windows 13, 15 and 17, only three of which are visible in the figure. Those windows extend through and define passages between the upper and lower sides of the primary mother board. As those skilled in the art appreciate, the number of such windows is based on the mechanical requirements required to feed cables through the backplane, the exact number and size of which may vary in different applications. Although not visible in Fig. 1, the portion of primary motherboard 3 underlying daughter board backplane 7 includes three cut-out regions 19, 21 and 23 defining three additional windows or passages, which are visible in the underside perspective view of Fig. 2 to which reference is made.

The bunched cable 11 contains a number of RF cables that are bunched together in a cable assembly. Individual RF cables branch from the cable 11, as illustrated, and are inserted through appropriate windows for distribution to the intended daughter board backplanes. The connector 12 of the cable 11 connects to the input-output panel of the equipment chassis, which is not a part of the invention and is not illustrated, where the individual coaxial RF lines are redistributed amongst a number of electronic circuits.

Before returning to Fig. 1, note is taken of RF cable connectors 16H, 16I and 16J attached to the ends of three respective branches of the bunched cable 11, and to the parallel rows of contacts revealed on the underside of the primary mother board, including rows of contacts 18 and 20.

Continuing with Fig. 1, primary mother board 3 also contains a plurality of connector electrical sockets, cylindrical passages, arranged in a plurality of parallel rows, formed in the board. Four of those parallel rows of electrical sockets are visible in Fig. 1; another four rows underlie daughter board backplanes 7 and 9. Those electrical sockets formed in the circuit board are recognized as vias, which are formed by the standard procedure of drilling holes through the circuit board, and then plating the walls of the holes with a conductive metal. Each group of such sockets, including electrical connectors 18 and 20, defines an electrical connectors. The latter electrical connectors provide the electrical connections to daughter board backplane 5, as hereinafter described.

The daughter board backplanes are considered next. Each daughter board backplane also constitutes a multi-layer circuit board, which contains between twelve and sixteen layers laminated together. Conductive patterns within the layers of the daughter board backplanes provide for interconnection, power and ground circuits. Each backplane illustrated is of a rectangular shape, as example, although other geometry's may be used in alternative embodiments. The daughter board backplanes may comprise a number of different sizes and areas with the only requirement being that the daughter board backplanes fit within the area bounded by the major surface of primary motherboard 3, an area which is selected by the designer. In this embodiment primary motherboard 3 is large enough in area to support the three daughter board backplanes illustrated and a fourth backplane, not illustrated, in the vacant space to the upper right. In other embodiments greater (or lesser) number of daughter board backplanes may be used.

Daughter board backplane 5 includes a plurality of multi-pin connectors, surface mount connectors that populate the upper surface, 10A, 10B, 10C, 10D and 10E. The connectors are aligned in parallel. Typically those connectors contain at least two (or more) rows of electrical contacts or sockets with up to 400 contacts in each connector. Each of those connectors preferably is press-fit into vias formed in the backplane. Daughter board backplane 5 is representative in structure. Daughter board backplanes 7 and 9, shown assembled in place, also contain surface mount connectors with backplane 7 containing eight such connectors and backplane 9 containing six such connectors. The pins of each connector electrically connect to respective portions of the conductor pattern, not illustrated, within the internal layers of the respective daughter board backplane. The surface mount connectors also provide the mounting and electrical connection to the Line Replaceable Modules, which plug into the respective surface mount connectors. The surface mount connectors extend electrical power, ground and circuit interconnections between those modules and the daughter board backplane.

Daughter board backplane 5 also includes a number of circular passages, such as 22, only one of which is visible in the figure. Those circular passages are provided to receive RF connectors as next described, such as those RF connectors 16H, 16I and 16J viewed in Fig. 2. The individual coaxial RF lines that branch from cable 11 that are visible in Fig. 1 are identified as 11A, 11B, 11C and 11D. An end of each coaxial cable 11A-11D (and other coaxial cables) extending from cable 11 includes an RF connector, such as connector 16D. Mechanically, the RF connector contains a cylindrical portion and a lower rim. The cylindrical portion of the RF connector is smaller in diameter than the circular passage 22 through the daughter board backplane and is greater in length than the thickness of the daughter board backplane so that the cylindrical portion may extend through the backplane and above the upper surface. The rim prevents the RF connector from being pulled or pushed through the daughter board backplane.

As shown, connector 16D of coaxial cable 11D is threaded from the underside of primary motherboard 3, through window 13 in the primary motherboard, and from the underside of daughter board backplane 5, through and into a circular passage 22 in the backplane. Daughter board backplane 5 supports a number of RF connectors 16A, 16B, 16C and 16D, associated with respective coaxial cables 11A-11D, each of which connectors is inserted into a respective circular passage formed in the daughter board backplane.

The system is not limited to RF cables and connections but may include fiber optic and digital interface cables as well. In the foregoing embodiment a fiber optic cable 27 is threaded through window 15 in primary motherboard 15 and connects to the underside of a fiber optic connector 28, located adjacent connector 10C.

Daughter board backplane 5 contains a pair of multi-contact electrical connectors 24 and 26 with depending contact pins on the left and right sides extending below the bottom surface of backplane 5. Daughter board backplanes 7 and 9 also contain the pairs of formed electrical connectors extending along the right and left sides. The contact pins in those connectors may electrically connect internally to conductive traces in the layers of the daughter board backplane and through those conductive traces electrically connect to appropriate contacts in the surface mount connectors, that populate the upper surface of the daughter board, such as 10A, 10B, 10C and 10D. The particular routing of the electrical connection is the choice of the designer and is not relevant or material to an understanding of the invention.

Each connector 24 and 26 on daughter board backplane 5 contains a plurality of contact pins that protrude or extend a predetermined distance from the bottom of the daughter board, giving the formed connector a "male" gender. Those contact pins are inserted into the respective female sockets of the respective connectors 18 and 20 on primary mother board 3 when the daughter board backplane is inserted into place on the primary mother board. When the connector portions of the daughter board backplane mates with the connectors on the primary mother board the electrical circuits are extended from the respective daughter board backplane through the primary motherboard. Like electrical connectors are formed in the primary mother board to mate with the male contacts of the electrical connectors on the other daughter board backplanes 7 and 9. Thus to assemble the system, the cable connectors are threaded through the windows in the primary mother board and are mounted to the daughter board backplane, and each daughter board backplane is then press-fit into place on the primary mother board.

Continuing with Fig. 1, a plurality of bolts 31 or other fasteners are used to mechanically secure the daughter board backplanes to primary mother board 3. The fasteners extend through holes 29 in the daughter board backplane and screw into "Helocoils" 33, threaded inserts that are inserted into holes in the primary mother board 3.

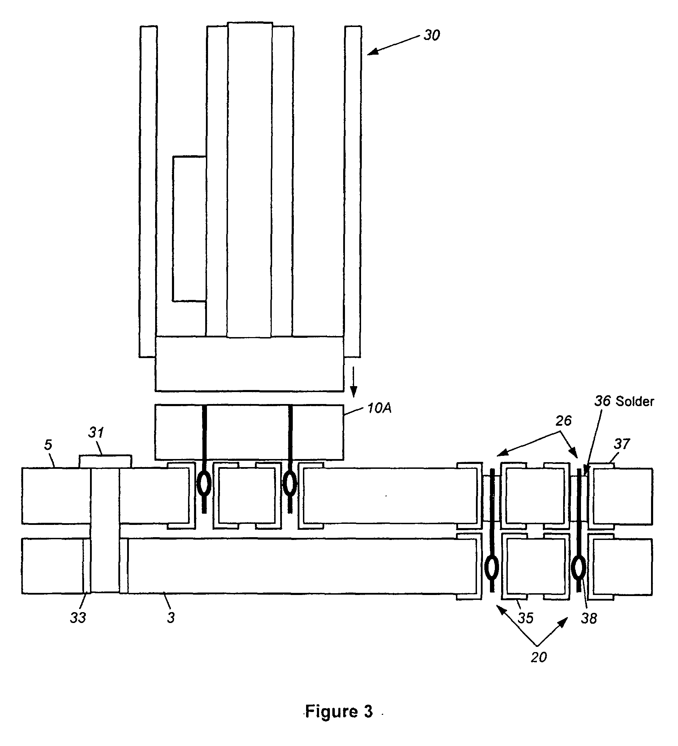

Reference is made to Fig. 3 which shows a partial side section view of portion of the assembled mother board and backplane illustrating the connectors. The daughter board backplanes provide the functional interface to the required hardware Line Replaceable Modules associated with the function of the respective daughter board backplane for the integrated electronic system. For purposes of illustration, one such Line Replaceable Module 30 is pictorially illustrated in side view Fig. 3. The LRM includes a central frame with circuit boards mounted to the right and left faces of the frame, one of which contains a large electronic component, and the foregoing are protected by an aluminum cover, shown on the far right and left sides of the module. The bottom of the module contains the electrical connector. It should be understood that the LRM is an example of one of many different styles of subassemblies that may be employed in the disclosed type of interconnection connection operation.

As shown by the arrows, the module plugs into a connector 10A in daughter board backplane 5. The daughter board backplanes are populated with a large number of such LRM's. Each of the connectors, such as connectors 10A, 10B and 10C in daughter board backplane 5, and the like connectors in each of the other daughter board backplanes, provide the electrical and/or RF, optical connection to an associated LRM.

In this embodiment, surface mount connectors, such as connector 10A, mounts electrically and mechanically to the respective daughter board backplanes by a press-fit pin-into-via connection that is like that used in connector 26, the latter of which is described hereafter in greater detail.

The detail of the daughter backplane to primary motherboard connection is illustrated to an enlarged scale in this scale in Fig. 3. The passages that form the electrical sockets of connector 20 in primary mother board 3 are formed of electrical vias, drilled holes through the circuit board that are plated with a conductive metal 35, a fairly conventional structure in the printed circuit board art. By design the metal of the via may connect to one or more metal traces, not illustrated, internal to one or more of the multiple layers that form primary mother board 3. The contact pins of connector 26 formed in daughter backplane are held in place to the daughter board with solder 36 to the walls of a via 37 in backplane 5. The extending portion of the contact pins contains a widened portion or rounded bulge 38 in its diameter. That bulge is sufficient in diameter to contact the metal walls of the via in the primary mother board and establish electrical contact therewith.

The bulge is located a short distance from the outermost end of the contact pin of connector 26. This permits the pins of the connector to be aligned with and positioned in the corresponding socket of the female connector for assembly before exerting a pressing force on the daughter board backplane that forces the pin (and other pins of the connector) further into the formed socket and the underside of daughter board backplane 5 in abutment with the upper surface of mother board 3. The bulge portion of the contact pins produces a wiping action against the walls of the via as the two boards are assembled together to ensure good electrical contact and engages the via walls with a frictional contact.

The foregoing attachment of the connectors (and of the daughter board backplane and daughter board) is a "press-fit". As a press fit, the metal male and female contacts so pressed together possess a definite electrical contact resistance. It is also possible to separate the two circuit boards at a later time, assuming that any bonding action that may occur through metal migration between the contact pin and the metal via over time is negligible and does not produce a significant adherence between the foregoing male and female contacts.

The upper side of primary mother board 3 is electrically non-conductive, except for the ends of the vias. That is, there are no metal circuit traces (e.g. conductor routings) formed on the top surface of the primary mother board, which eliminates the possibility of an inadvertent electrical contact with another circuit board or object. The daughter board backplanes contains some vias and the front and rear ends of those vias are of conductive metal. Any physical contact between the bottom surface of a daughter board backplane and the insulated upper surface of primary mother board 3 will not have any adverse electrical consequence, and will not cause a short-circuit.

Continuing with Fig. 3, in the illustrated embodiment the distal end of the contact pins of connector 24 do not extend entirely through primary mother board 3. The length of the pin as measured from the bottom of daughter board backplane 5 to the distal end of the pin is less than the thickness of back plane 3. Hence, the ends of the contact pins cannot poke through the underside of the primary mother board . In that way the pins are electrically isolated from any metal walls that may underlie the primary mother board as may be found when the primary mother board is installed in a rack or cabinet. The length of the contact pin may be customized to each particular application In other embodiments the contact pins may be of greater length, which allows easier access to those pins for electrical testing purposes.

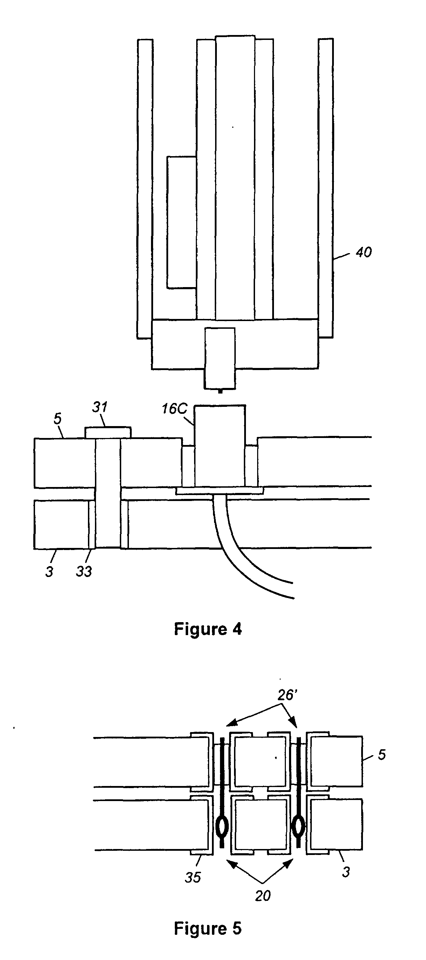

Fig. 4 illustrates the RF connector 16C in side view and adjacent portions of the daughter board backplane and primary motherboard. An "RF" LRM 40 is also illustrated. The RF connector in the base of the module 40 plugs into RF coaxial connector 16C. Other elements in the figure that were previously identified in previous figures are given the same identification number in Fig. 4, and need not be further described.

Fig. 5 illustrates an alternative for the daughter backplane to primary mother board electrical connector 26 and 20 earlier illustrated in Fig. 3. Instead of the solder connection to the daughter board backplane, connector 26' employs a double press-fit contact pin. The contact pin contains two spaced bulges along the pin axis. One bulge engages the walls of via 37 in the backplane and the other engages the via walls 35 as in the prior embodiment. Other elements identified are the same elements described in connection with the preceding figures, which need not be repeated.

By design, each of the daughter board backplanes contains the electronic circuits and/or connections, including those to associated LRM's, that perform a separate or defined function related, as example, to RF receiver bands, power, digital processing and system security. As example daughter board backplane 5 may contain the RF transmitter, daughter board backplane 7 the power supplies, daughter board backplane 9, the RF receiver and the digital processing subsystem.

With the segmented backplane assembly the functions of the integrated electronic system may be compartmentalized amongst a number of daughter board backplanes. When a particular functional unit needs to be replaced, as example, should the functional unit be upgraded in design, one first removes the entire backplane assembly. Then by removing any capture bolts 31, the daughter board backplane may be pulled from the assembly and replaced. The remaining functional units on the primary mother board remain undisturbed. Each of the smaller daughter board backplanes can be utilized as a complete test backplane to functionally test each of the hardware elements with the assistance of appropriate test interfaces. Testing may include portions of a function, such as the RF receiver chain, the transmission chain or the digital subsystem.

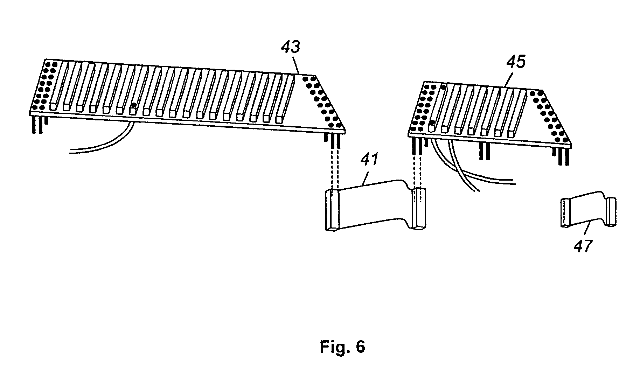

As an additional feature, when more than one daughter board backplane is required for testing, as in the case of RF and digital processing assets, a number of the daughter board backplanes may be interconnected by ribbon cables and RF coaxial cables, such as is pictorially illustrated in Fig. 6, to provide complete functionality. Thus ribbon cable 41 connects a right side connector of daughter board backplane 43 to the' left side connector of another daughter board backplane 45, respectively denominated as the RF backplane and the digital backplane. A ribbon cable 47 connects the right side connector on daughter board backplane 45 to the test equipment, not illustrated. The ribbon cables may be supplied with the integrated electronic system or may be packed therewith as test system cables as a kit. The foregoing feature may be included as an option in those systems in which the system complexity dictates integration at lower functional levels.

It is believed that the foregoing description of the preferred embodiments of the invention is sufficient in detail to enable one skilled in the art to make and use the invention. However, it is expressly understood that the detail of the elements presented for the foregoing purpose is not intended to limit the scope of the invention, in as much as equivalents to those elements and other modifications thereof, all of which come within the scope of the invention, will become apparent to those skilled in the art upon reading this specification. Thus, the invention is to be broadly construed within the full scope of the appended claims.

## Claims

1. A backplane interconnection assembly, comprising:
a primary mother board having a major surface extending over a predetetermined area;
a plurality of daughter board backplanes, each of said daughter board backplanes having a major surface, said major surface defining respective areas, smaller in size than said predetermined area;
each of said daughter board backplanes being mounted to said primary mother board at respective locations on said major surface of said primary mother board with said major surface area of each of said daughter board backplanes oriented parallel to said major surface of said primary mother board.

2. The backplane interconnection assembly as defined in claim 1, wherein each of said daughter board backplanes include at least a first pair of electrical connectors, said connectors including a plurality of extending contact pins; and wherein said primary mother board includes a like plurality of electrical connectors for each of said daughter board backplanes, said electrical connectors of said primary mother board for mating to said electrical connectors of said daughter board backplanes; wherein each of said connectors of said daughter board backplane mates with associated mating connectors on said primary mother board when said daughter board backplanes are mounted on said major surface of said primary mother board.

3. The backplane interconnection assembly as defined in claim 2, wherein each of said electrical connectors on said primary mother board comprises a plurality of electrical vias, said vias comprising metal walled passages through said primary motherboard, wherein said extending contact pins of said respective daughter board backplanes frictionally contact said metal walls of respective passage to provide electrical paths therebetween.

4. The backplane interconnection assembly as defined in claim 3, wherein said primary mother board is of a predetermined thickness; wherein said extending contact pins extend from a surface of a respective daughter board backplane by a predetermined distance; and wherein said predetermined distance is less than said predetermined thickness, whereby said contact pins cannot extend through said primary motherboard when said associated daughter board backplanes are mounted to said primary mother board.

5. The backplane interconnection assembly as defined in claim 3, further comprising: fastener means for securing said daughter board backplanes to said primary mother board.

6. The backplane interconnection assembly as defined in claim 5, wherein said fastener means comprise bolts.

7. The backplane interconnection assembly as defined in claim 4, further comprising: fastener means for securing said daughter board backplanes to said primary mother board.

8. The backplane interconnection assembly as defined in claim 7, wherein said fastener means comprise bolts
